# EUROPEAN PATENT APPLICATION

(11) **EP 0 637 079 A1**
(43) Date of publication of application: **01.02.1995**
(21) Application number: 94303974.3
(22) Date of filing: 02.06.1994
(51) Int. Cl.: H01L 23/40, H05K 7/20

(54) **Upgradable multi-chip module**

(30) Priority: 30.07.1993 US 99740
(71) Applicant: SUN MICROSYSTEMS, INC., Mountain View, CA 94043 (US)
(72) Inventor: Loo, Mike C., San Jose, California 95148 (US); Conte, Alfred S., Hollister, California 95023 (US)
(74) Representative: Wombwell, Francis

(57) **Abstract**

A substrate, an alignment plate, a heat sink, a back plate, a plurality of spacers, and a plurality of nuts are used to removably package a number of semiconductor packages into a single module. The semiconductor dies are packaged with TAB packages having LGA outer lead bumps. The substrate comprises a number of land patterns, a number of alignment cavities, and a number of join cavities. The alignment plate is fabricated with a number of alignment pins, a number of housing cavities, and a number of join cavities. The heat sink is fabricated with a number of stems and a number of join cavities. The back plate is fabricated with a number of extrusions having threaded ends. The spacers are fabricated with flanged openings at both ends, and each spacer is loaded with a number of spring washers. The nuts are fabricated with stepped heads. The extrusions, the land patterns and the alignment and join cavities of the substrate, the alignment pins and the housing and join cavities of the alignment plate, the stems and the join cavities of the heat sink, the spring washer loaded spacers, and the stepped head nuts are coordinated in their numbers, sizes and geometric locations. As a result, the semiconductor packages may be easily replaced at a later time with enhanced versions, and the replaced semiconductor packages are salvageable.

## Description

### BACKGROUND OF THE INVENTION

### 1. Field of the Invention:

The present invention relates to the field of semiconductor packaging. More specifically, the present invention relates to packaging a plurality of semiconductor packages, including very large scale integration (VLSI) chips, into a single module.

### 2. Background:

Packaging a plurality of semiconductor packages into a single module is well known in the art. Typically, the semiconductor packages are mounted onto the module by one of a number of well known techniques, such as flip chip, tape automated bonding (TAB) or wire bonding. These prior art mounting/packaging techniques all have a common disadvantage in that they require the semiconductor packages to be permanently mounted to the board or substrate of the module. The only way to upgrade the digital system comprising the module is to replace the entire module, and the permanently mounted semiconductor packages are not salvageable. This is especially undesirable when the semiconductor packages are the more costly VLSI microprocessor chip and related application specific integrated circuits (ASICs), and the digital system is a microprocessor based computer system. Thus, it is desirable to be able to package a number of semiconductor packages into a single module in an upgradable manner. That is, the semiconductor packages are not permanently mounted, they can be easily replaced with enhanced versions at a later time, and the replaced semiconductor packages are salvageable. As will be disclosed, the present invention provides for an upgradable multi-chip module which advantageously achieves the desired results.

### SUMMARY OF THE INVENTION

The desired results are advantageously achieved by packaging the semiconductor dies with TAB packages having land grid array (LGA) outer lead bumps. The semiconductor packages are then packaged into a single module using a substrate, an alignment plate, a heat sink, a back plate, a plurality of spacers, and a plurality of nuts. The substrate comprises a plurality of land patterns, a plurality of alignment cavities, and a plurality of join cavities. The alignment plate is fabricated with a number of alignment pins, a plurality of housing cavities, and a plurality of join cavities. The heat sink is fabricated with a plurality of stems, and a plurality of join cavities. The back plate is fabricated with a number of extrusions having threaded ends. The spacers are fabricated with flanged openings at both ends, and each spacer is loaded with a number of spring washers. The nuts are fabricated with stepped heads. The extrusions of the back plate, the land pattern and the alignment and join cavities of the substrate, the alignment pins and the housing and join cavities of the alignment plate, the stems and the join cavities of the heat sink, the spring washer loaded spacers, and the stepped head nut are coordinated in their numbers, sizes and geometric locations.

The substrate is first removably placed on top of the back plate, with the join cavities of the substrate accommodating the extrusions. The alignment plate is then removably placed on top of the substrate, with the alignment cavities of the substrate accommodating the alignment pins, and the join cavities of the alignment plate accommodating the extrusions. The semiconductor packages are then removably placed on top of the land pattern of the substrate, with the housing cavities of the alignment plate accommodating the semiconductor packages. The heat sink is then removably placed on top of the alignment plate, with the stems making direct contact with the semiconductor packages and the join cavities of the heat sink accommodating the extrusions. Next, the spring washer loaded spacers are removably slipped onto the extrusions of the back plate. Finally, the back plate, the substrate, the semiconductor packages, the alignment plate, the heat sink, and the spring loaded spacers are removably joined together as a single module, and secured by removably threading the stepped head nuts onto the threaded ends of the extrusions until they firmly press against the spring washer loaded spacers.

### BRIEF DESCRIPTION OF THE DRAWINGS

The objects, features, and advantages of the present invention will be apparent from the following detailed description of the presently preferred and alternate embodiments of the invention with references to the drawings in which:
**FIGURE 1** is an exploded front perspective view of the upgradable multi-chip package of the present invention.
**Figure 2** is the top view of the upgradable multi-chip module of the present invention.
**Figure 3** is the bottom view of the upgradable multi-chip module of the present invention.
**Figure 4** is a cross sectional view of the upgradable multi-chip module of the present invention.

### DETAILED DESCRIPTION

### PRESENTLY PREFERRED AND ALTERNATE EMBODIMENTS

In the following description, for purposes of explanation, specific numbers, materials and configurations are set forth in order to provide a thorough understanding of the present invention. However, it will be apparent to one skilled in the art that the present invention may be practiced without the specific details. In other instances, well known systems are shown in diagrammatical or block diagram form in order not to obscure the present invention unnecessarily.

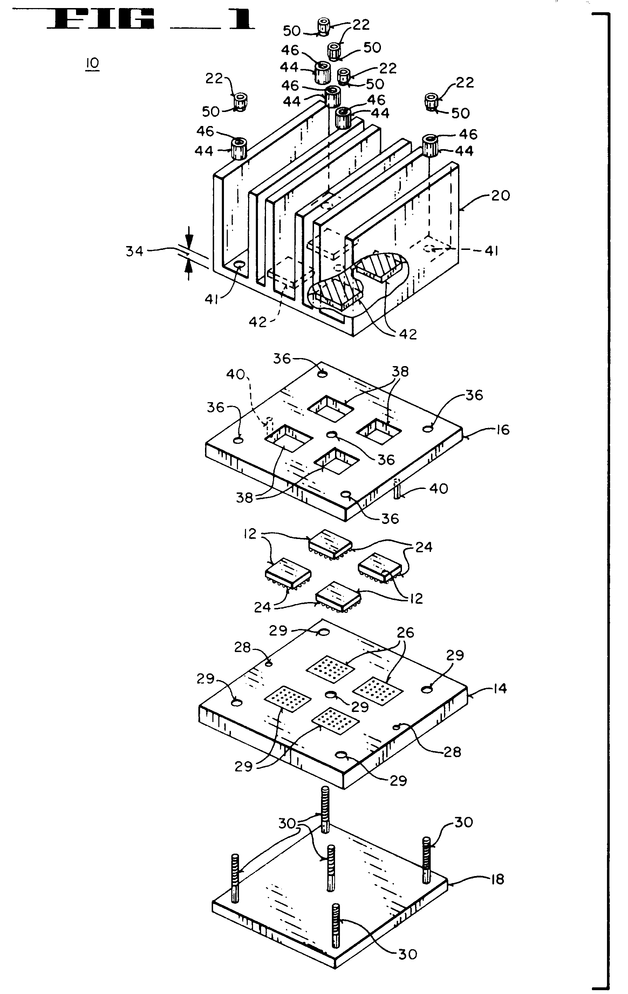

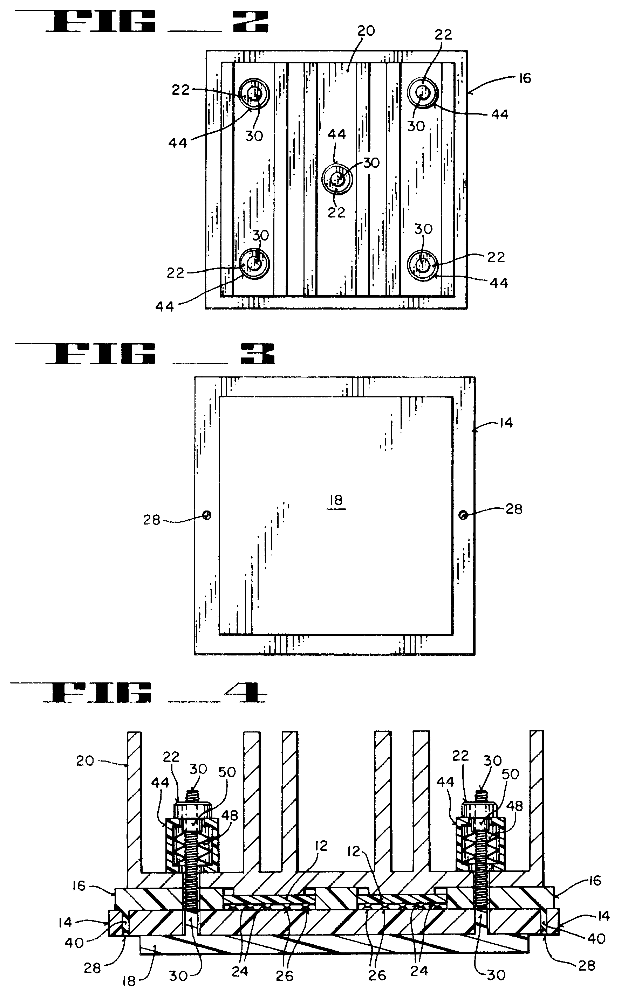

Referring now to **Figures 1-4**, the upgradable multi-chip module of the present invention **10** comprises a number of semiconductor packages **12**, a substrate **14**, an alignment plate **16**, a heat sink **20**, a back plate **18**, a plurality of spacers **44**, and a plurality of nuts **22**. For ease of illustration and understanding, only four semiconductor packages **12** and five sets of nuts and spacers **22** and **44** are shown, however, based on the description to follow, it will be appreciated that the present invention may be practiced with two or more semiconductor packages, and more or less nut and spacer sets.

The semiconductor dies (not shown) are packaged using TAB semiconductor packages **12** with LGA outer lead bumps **24**. The LGA outer lead bumps **24** may or may not be cushioned, depending on the sizes of the inter-bump pitches. TAB semiconductor packages with uncushioned LGA outer lead bumps are well known in the art.

The substrate **14** comprises a plurality of land patterns **26**, a plurality of alignment cavities **28**, and a plurality of join cavities **29**. The substrate **14** is made of well known materials, such as glass epoxy laminated ceramic, and the land patterns **26** are formed using a well known conductive material, such as gold. The land patterns **26**, the alignment cavities **28**, and the join cavities **29** are disposed on the substrate **14** in a symmetrical manner. While the land patterns **26** are shown in the four quadrants, the alignment cavities **28** are shown at the mid-point of two outer edges, and the join cavities **29** are shown in the four corners and the center, it will be appreciated that the land patterns **26** and the alignment and join cavities **28** and **29** may be disposed in other symmetrical manners. The numbers and sizes of the alignment and join cavities **28** and **29** will be described in further detail below.

The alignment plate **16** is fabricated with a number of alignment pins **40**, a plurality of housing cavities **38**, and a plurality of join cavities **36**. The alignment plate **16** is made of a well known polymer material, such as polyphenylene sulfide. The geometric locations of the alignment pins **40** are precisely coordinated with the alignment cavities **28** of the substrate **14**. The precision is dependent on the inter-bump pitches of the LGA outer lead bumps **24**. For inter-bump pitches between 0.8 mm and 0.5 mm, preferably, the precision is within +/- 0.07 mm. The numbers and planery sizes of the alignment pins **40** are also coordinated with the alignment cavities **28** of the substrate **14**. Additionally, the lengths of the alignment pins **40** are coordinated with the thickness of the substrate **28**. The numbers, sizes, and geometric locations of the housing cavities **38** are coordinated with the semiconductor packages **12** and the land patterns **26** of the substrate **14**. The numbers, sizes, and geometric locations of the join cavities **36** are coordinated with the join cavities **29** of the substrate **14**. While for ease of illustration and understanding, only two alignment pins are shown, it will be appreciated that the present invention may be practiced with one or more alignment pins.

The heat sink **20** is fabricated with a plurality of stems **42** and a plurality of join cavities **41**. The heat sink **20** is made of a well known thermal conductive material, such as, aluminum or copper. The numbers and sizes of the stems **42** are coordinated with the semiconductor packages **12**, the housing cavities **38** of the alignment plate **16**, and the land patterns **26** of the substrate **14**. The numbers, sizes, and geometric locations of the join cavities **41** are coordinated with the join cavities **36** of the alignment plate **16**, and the join cavities **29** of the substrate **14**. While a fork type of heat sink **20** is shown, it will be appreciated that the present invention may be practiced with other types of heat sinks.

The back plate **18** is fabricated with a number of extrusions **30** having threaded ends. The back plate **18** is also made of a well known metallic material, such as aluminum or stainless steel. The heights of the extrusions **30** are coordinated with the thicknesses of the substrate **14**, the alignment plate **16**, the heat sink **20** (i.e. the base height **34** of the fork type heat sink **20** shown), the spacers **44** and the nuts **22**. The numbers, planery dimensions and the geometric locations of the extrusions **30** are coordinated with the inside dimensions of the join cavities **29** of the substrate **14**, the join cavities **36** of the alignment plate **16**, and the join cavities **41** of the heat sink **20**.

The spacers **44** are fabricated with flanged openings **46** at both ends. Additionally, each spacer **44** is loaded with a number of spring washers **48** of known spring constant during deflection. The inside dimensions of the spacers **44** are coordinated with the total dimensions of the spring washers **48** used. Preferably, eight to twelve spring washers **48**, each having a spring constant of 3K lb/in to 8K lb/in during deflection, are loaded in each spacer **44**. However, springs or other similar materials may also be used in lieu of the spring washers.

The nuts **22** are fabricated with stepped heads **50**. The outside dimensions of the steps of the stepped heads **50** are coordinated with the inside dimensions of the flanged openings **46** of the spacers **44**, allowing the stepped heads **50** of the nuts **22** to apply pressure to the spring washers **48** loaded in the spacers **44**.

The substrate **14** is first removably placed on top of the back plate **18**, with the join cavities **29** of the substrate **14** accommodating the extrusions **30**. The alignment plate **16** is then removably placed on top of the substrate **14**, with the alignment cavities **28** of the substrate **14** accommodating the alignment pins **40**, and the join cavities **36** of the alignment plate **16** accommodating the extrusions **30**. The semiconductor packages **12** are then removably placed on top of the land patterns **26** of the substrate **14**, with the housing cavities **38** of the alignment plate **16** accommodating the semiconductor packages **12**. The heat sink **20** is then removably placed on top of the alignment plate **16**, with the stems **42** making direct contact with the semiconductor packages **12**, and the join cavities **41** accommodating the extrusions **30**. Next, the spring washer **48** loaded spacers **44** are slipped onto the extrusions **30** of the back plate **18**. Finally, the back plate **18**, the substrate **14**, the semiconductor packages **12**, the alignment plate **16**, the heat sink **20**, and the spring washer **48** loaded spacers **44** are removably joined together as a single module **10**, and secured by removably threading the stepped head nuts **22** onto the threaded ends of the extrusions **30** until they firmly press against the spring washer **48** loaded spacers **44**.

As a result of the constant deflection of the spring washers **48** caused by the pressure applied to the spring washers **48** by the stepped head nuts **22**, constant pressure is applied to the semiconductor packages **12** by the stems **42** of the heat sink **20**. In turn, the constant pressure applied to the semiconductor packages **12** causes physical and electrical contacts between the LGA outer lead bumps **24** of the semiconductor packages **12** and the land patterns **26** of the substrate **14** to be maintained.

While the present invention has been described in terms of presently preferred and alternate embodiments, those skilled in the art will recognize that the invention is not limited to the embodiments described. The method and apparatus of the present invention can be practiced with modification and alteration within the spirit and scope of the appended claims. The description is thus to be regarded as illustrative instead of limiting on the present invention.

## Claims

1. A multi-chip module comprising:
a) a plurality of semiconductor packages having a first plurality of densely disposed electrical contacts;
b) a substrate comprising a second plurality of densely disposed electrical contacts, said semiconductor packages being removably placed on top of said substrate with said first and second plurality of densely disposed electrical contacts precisely contacting each other correspondingly;
c) alignment means removably cooperating with said semiconductor packages and said substrate for maintaining said precise contacts between said first and second densely disposed electrical contacts;
d) heat dissipation means removably cooperating with said alignment means and said semiconductor packages for directly conducting heat away from said semiconductor packages during operation; and
e) join means cooperating with said substrate, said alignment means, and said heat dissipation means for removably joining said substrate, said alignment means, and said heat dissipation means.

2. The multi-chip module as set forth in claim 1, wherein,
said semiconductor packages are TAB semiconductor packages;
said first plurality of densely disposed electrical contacts are densely disposed LGA outer lead bumps;
said second plurality of densely disposed electrical contacts are densely disposed pad of land patterns.

3. The multi-chip module as set forth in claim 2, wherein, said land patterns are disposed on said substrate in a symmetrical manner.

4. The multi-chip module as set forth in claim 1, wherein,
said alignment means is an alignment plate having a plurality of alignment pins; and
said substrate also has a plurality alignment cavities for accommodating said alignment pins when said alignment plate is removably placed on top of said substrate, said alignment cavities and said alignment pins being coordinated in numbers, sizes and geometric locations.

5. The multi-hip module as set forth in claim 4, wherein, said alignment pins and said alignment cavities are disposed on said alignment plate and said substrate respectively in a symmetric manner.

6. The multi-chip module as set forth in claim 5, wherein,
said alignment plate and said substrate comprise two alignment pins and two alignment cavities respectively;
said two alignment pins and said two alignment cavities being disposed at mid-points of opposite edges of said alignment plate and said substrate respectively.

7. The multi-chip module as set forth in claim 4, wherein,
said alignment plate also has a plurality of housing cavities for accommodating said semiconductor packages when said alignment plate is removably placed on top of said substrate after semiconductor packages have been removably placed on top of said substrate; and
said heat dissipation means is a heat sink having a plurality of stems for making direct physical contact with said semiconductor packages when said heat sink is removably placed on top of said alignment plate, said semiconductor packages, said housing cavities, and said stems being coordinated in numbers, sizes and geometric locations.

8. The multi-chip module as set forth in claim 7, wherein,
said housing cavities and said stems are disposed on said alignment plate and said heat sink in a symmetric manner.

9. The multi-chip module as set forth in claim 8, wherein,
said multi-chip module comprises four semiconductor packages;
said alignment plate and said heat sink comprise four housing cavities and four stems respectively;
said four housing cavities and said four stems being disposed in four quadrants of complimentary surfaces of said alignment plate and said heat sink.

10. The multi-chip modules as set forth in claim 7, wherein,
said substrate also comprises a first plurality of join cavities;
said alignment plate also comprises a second plurality of join cavities;
said heat sink also comprises a third plurality of join cavities;
said join means comprises a back plate having a plurality of extrusions having threaded ends, a plurality of spacers, and a plurality of mating nuts,
said extrusions being coordinated with said first, second, and third plurality of join cavities in numbers, sizes, and geometric locations, each of said spacers having flanged openings at both of its ends and being loaded with spring washers of known deflection constants, said mating nuts having stepped heads,
said back plate, said substrate, said semiconductor packages, said alignment plate, said heat sink, and said spring washer loaded spacers being removably joined together and secured as a single module by removably threading said mating nuts onto said threaded ends of said extrusions until said mating nuts firmly press against said spring washer loaded spacers correspondingly, said extrusions being accommodated by said first, second, and third plurality of join cavities when said back plate, said substrate, said semiconductor modules, said alignment plate, said heat sink, and said spring washer loaded spacers are removably joined together and secured as a single module.

11. The multi-chip module as set forth in claim 10, wherein, said first, second and third plurality of join cavities, and said extrusions are disposed on said substrate, said alignment plate, said heat sink, and said back plate in a symmetric manner.

12. The multi-chip modules as set forth in claim 11, wherein,
said join means comprises five extrusions, five spacers, and five mating nuts;
said substrate, said alignment plate, and said heat sink comprise a first, a second, and a third five join cavities respectively;
said first, second, and third five join cavities are symmetrically disposed at corners and centers of said substrate, said alignment plate, and said heat sink respectively.

13. A multi-chip module comprising:
a) a plurality of semiconductor packages having a plurality of semiconductor dies packaged with tapes having densely disposed LGA outer lead bumps;
b) a substrate comprising a plurality of land patterns with densely disposed pads, a plurality of housing cavities, and a first plurality of join cavities, said semiconductor packages being removably placed on top of said land patterns with said densely disposed LGA outer lead bumps precisely contacting said densely disposed pads;
c) an alignment plate having a plurality of alignment pins, a plurality of housing cavities, and a second plurality of join cavities, said alignment pins being coordinated with said alignment cavities in numbers, sizes, and geometric locations, said housing cavities being coordinated with said semiconductor packages and said land patterns in numbers, sizes, and geometric locations, said alignment plate being removably placed on top of said substrate with said housing cavities accommodating said semiconductor packages, and said alignment pins accommodated by said alignment cavities;
d) a heat sink having a plurality of stems and a third plurality of join cavities, said stems being coordinated with said semiconductor packages and said land patterns in numbers, sizes and geometric locations, said heat sink being removably placed on top of said alignment plate with said stems contacting said semiconductor packages directly;
e) a back plate having a plurality of extrusions having threaded ends, said extrusions being coordinated with said first, second and third plurality of join cavities in numbers, sizes, and geometric locations, said back plate being placed underneath said substrate with said extrusions being accommodated by said first, second, and third plurality of join cavities;
f) a plurality of spacers, said spacers being coordinated with said extrusions in numbers and sizes, each of said spacers having flanged openings at both of its ends and being loaded with spring washers with known deflection constants; and
g) a plurality of nuts having stepped heads, said step headed nuts being coordinated with said spacers and said extrusions of said back plate in numbers and sizes, said nuts being removably threaded onto said threaded ends of said extrusions firmly joining and securing said back plate, said substrate, said semiconductor packages, said alignment plates, said heat sink, and said spring washer loaded spacers together as a single module.

14. The multi-chip module as set forth in claim 13, wherein,
said land patterns, said alignment cavities, and said first plurality of join cavities are disposed on said substrate in a symmetric manner;
said alignment pins, said housing cavities, and said second plurality of join cavities are disposed on said alignment plate in a symmetric manner;
said stems and said third plurality of join cavities are disposed on said heat sink in a symmetric manner; and
said extrusions are disposed on said back plate in a symmetric manner.

15. The multi-chip module as set forth in claim 14, wherein,
said multi-chip modules comprises four semiconductor packages;
said substrate comprises four land patterns, two alignment cavities, and a first five of join cavities;
said alignment plate comprises two alignment pins, four housing cavities, and a second five of join cavities;
said heat sink comprises four stems and a third five of join cavities; and
said back plate comprises five extrusions;
said four land patterns and said four stems being disposed in quadrants of said substrate and heat sink respectively;
said two alignment pins and said two alignment cavities being disposed at mid-points of opposite edges of said alignment plate and said substrate respectively;
said extrusions, and said first, second, and third five of join cavities being disposed at corners and centers of said black plate, said substrate, said alignment plate, and said heat sink respectively.
